# EUROPÄISCHE PATENTANMELDUNG

(11) **EP 1 993 143 A1**
(43) Veröffentlichungstag der Anmeldung: **19.11.2008**
(21) Anmeldenummer: 07009630.0
(22) Anmeldetag: 14.05.2007
(51) Int. Cl.: H01L 31/0216, H01L 31/052

(54) **Halbleiterbauelement, Verfahren zu dessen Herstellung und dessen Verwendung**

(71) Anmelder: Fraunhofer-Gesellschaft zur Förderung der angewandten Forschung e.V., 80686 München (DE)
(72) Erfinder: Dimroth, Frank, 79115 Freiburg (DE); Fernandez, Jara, 79106 Freiburg (DE); Janz, Stefan, 79106 Freiburg (DE)
(74) Vertreter: Pfenning, Meinig & Partner GbR

(57) **Zusammenfassung**

Die Erfindung betrifft ein Halbleiterbauelement, das mindestens eine Germanium-haltige Halbleiterschicht enthält. Die Halbleiterschicht weist rückseitig, d.h. auf der dem einfallenden Licht abgewandten Seite mindestens eine Siliciumcarbid enthaltende Schicht auf, die zum einen der Reflexion von Strahlung als auch als Rückseitenpassivierung oder als Diffusionsbarriere dient. Ebenso wird ein Verfahren zur Herstellung derartiger Halbleiterbauelemente beschrieben. Verwendung finden die erfindungsgemäßen Halbleiterbauelemente insbesondere als Thermophotovoltaikzellen oder Mehrfachsolarzellen auf Germanium-Basis.

## Beschreibung

Die Erfindung betrifft ein Halbleiterbauelement, das mindestens eine Germanium-haltige Halbleiterschicht enthält. Die Halbleiterschicht weist rückseitig, d.h. auf der dem einfallenden Licht abgewandten Seite mindestens eine Siliciumcarbid enthaltende Schicht auf, die zum einen der Reflexion von Strahlung als auch als Rückseitenpassivierung oder als Diffusionsbarriere dient. Ebenso wird ein Verfahren zur Herstellung derartiger Halbleiterbauelemente beschrieben. Verwendung finden die erfindungsgemäßen Halbleiterbauelemente insbesondere als Thermophotovoltaikzellen oder Mehrfachsolarzellen auf Germanium-Basis.

In der Thermophotovoltaik werden Photovoltaikzellen dazu verwendet, die Strahlung eines Ermittlers mit einer typischen Temperatur von 1000 bis 1500°C in elektrischen Strom umzuwandeln. Als Wärmequelle in einem solchen System können konventionelle Energiequellen wie Erdgas, oder regenerative Quellen wie konzentriertes Sonnenlicht verwendet werden. Aufgrund der im Vergleich zur Sonnen niedrigen Emittertemperaturen werden in der Thermophotovoltaik Zellen mit geringerer Bandlückenenergie eingesetzt. Beispiele sind Photovoltaikzellen aus Galliumantimonid, Galliumindiumarsenidantimonid oder Germanium. Germanium ist aufgrund der geringen Kosten und der guten Verfügbarkeit ein besonders interessantes Material für die Thermophotovoltaik.

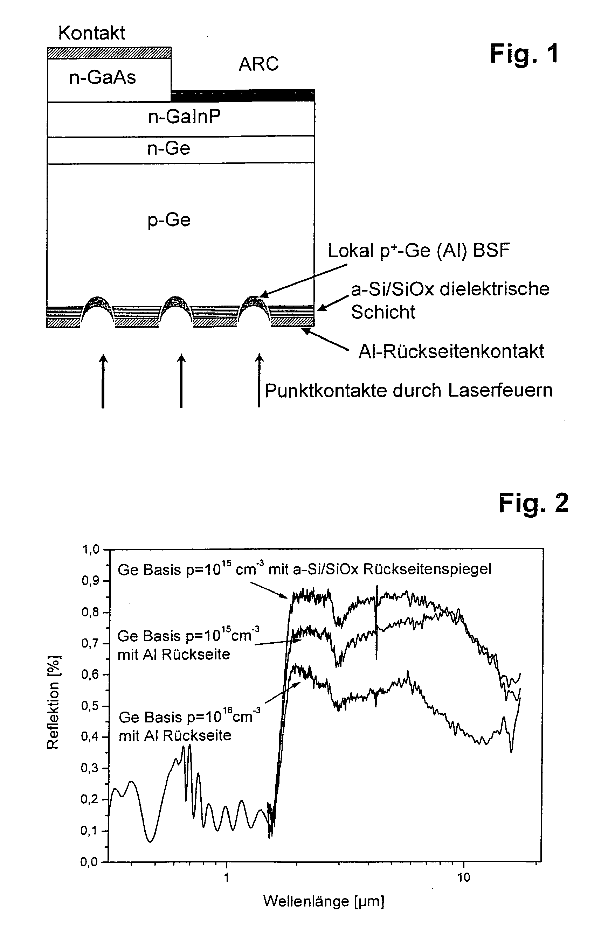

Aus dem Stand der Technik ist eine Thermophotovoltaikzelle auf Germanium-Basis mit einer Rückseitenpassivierung aus amorphem Silicium (EP 1 475 844 A2) und einem Rückseitenspiegel aus amorphem Silicium (a-Si) und SiOₓ bekannt (Fernandez, J., et al. Back-Surface Optimization of Germanium TPV Cells. in Proc. of 7th World TPV Conference. 2006. E1 Escorial, Spain). Diese Zelle weist einen Rückseitenkontakt aus Aluminium auf, der lokal mit einem Laser durch die dielektrischen Schichten getrieben wird. Die hier beschriebene Zelle und deren Verwendung ist in Fig. 1 schematisch dargestellt. Fig. 2 zeigt ein Reflexionsspektrum dieser Thermophotovoltaikzelle. Hieraus ist zu erkennen, dass die höchste Reflektivität von bis zu 85 % im langwelligen Spektralbereich bei niedrigen Substratdotierungen von p=10¹⁵ cm⁻³ mit dem dielektrischen Rückseitenspiegel aus a-Si/SiOₓ erreicht wird. Entscheidend für eine hohe Reflektivität des Rückseitenspiegels sind der Unterschied im Brechungsindex der Materialien sowie eine optimale Anpassung der Schichtdicken. Der Brechungsindex von amorphem Silicium liegt bei etwa 3,6 bis 4,3 (bei 633 nm), der von Siliciumoxid bei etwa 1,4 (bei 633 nm).

Weitere auf Germanium basierende Solarzellen sind aus dem Bereich der Mehrfachsolarzellen mit mehreren seriell verschalteten pn-Übergängen bekannt, wie sie in Satelliten und terrestrischen PV-Konzentratorsystemen zum Einsatz kommen.

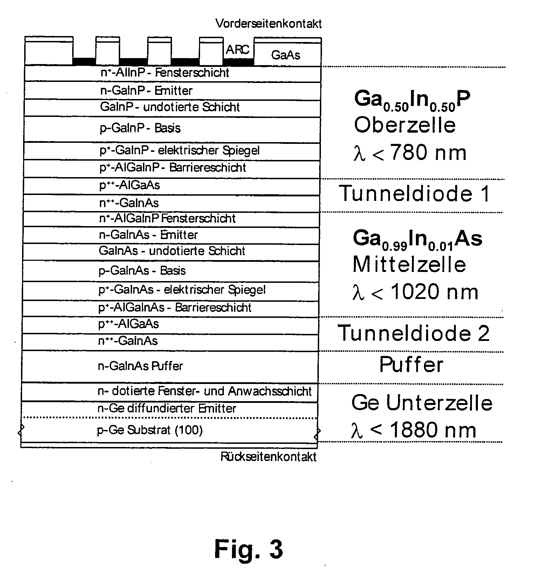

Fig. 3 zeigt den schematischen Aufbau der Schichtstruktur für eine III-V-Mehrfachsolarzelle, wie sie aus dem Stand der Technik bekannt ist (Bett et al., "Multi-junction Concentrator Solar Cells" in: Luque et al., Concentrator Photovoltaics, ISBN: 978-3-540-68796-2), mit drei pn-Übergängen aus GaInP, GaInAs und Germanium. Die Germanium-Teilzelle wird durch eine Diffusion von Phosphor oder Arsen während des Wachstums der darüber liegenden Schichtstruktur in das p-dotierte Germanium-Substrat gebildet. Die Germanium-Teilzelle besteht typischerweise aus einem Emitter mit einer Dicke von 100 bis 500 nm. Die Basisdicke entspricht in etwa der Dicke des Germanium-Substrats und beträgt für die Anwendung im Weltraum zwischen 130 bis 170 µm, für die Anwendung in terrestrischen Konzentratorsystemen 150 bis 500 µm. Die Rückseite der Germanium-Teilzelle ist vollständig mit einem Metall-Kontakt bedeckt. In diesem Fall trägt die Basis der Germanium-Solarzelle kaum zur Stromgeneration bei. Dies liegt zum einen daran, dass bei den heutigen Weltraum Solarzellen typischerweise Substratdotierungen von p>10¹⁷ cm⁻³ verwendet werden, wobei die Diffusionslänge für Minoritätsladungsträger in diesem Fall grundsätzlich kleiner ist als die Dicke der Basisschicht von etwa 150 µm. Zum anderen ist die Rekombinationsgeschwindigkeit für Minoritätsladungsträger an der Grenzfläche zwischen dem Germanium und der Metallschicht sehr hoch.

In den heute eingesetzten III-V-Mehrfachsolarzellen wird die Rückseite der Germanium-Teilzelle nicht passiviert. Will man die Solarzelle in Zukunft weiter verbessern, so ist eine Rückseitenpassivierung der Ge-Zelle wichtig.

Eine hohe Reflektivität für Wellenlängen größer 1850 nm dient bei der Weltraumsolarzelle dazu, die Temperatur der Solarzelle zu senken. Diese langwelligen Photonen werden in den heutigen Weltraumsolarzellen typischerweise am Rückseitenkontakt absorbiert und tragen zur Erwärmung der Solarzelle bei. Durch den Reflektor aus Siliciumcarbid können diese Photonen aus der Solarzelle heraus und zurück in den Weltraum emittiert werden. Heute wird diese Funktion zum Teil von speziellen Deckgläsern für die Weltraumanwendung erfüllt, die auf der Vorderseite der Solarzelle angebracht werden. In Russell, J., et al., A new UVR/IRR Coverglass for triple junction cells, in Proceedings of the 4th World Conference on Photovoltaic Energy Conversion. 2006. Waikoloa, Hawaii, USA wird gezeigt, dass durch einen Infrarotspiegel auf dem Deckglas eine Reduktion der Solarzellentemperatur im Weltraum um 9 - 13 °C erwartet werden kann. Dies entspricht einer Verbesserung des absoluten Wirkungsgrads um 0.5 bis 0.7 %. Der hier beschriebene Reflektor auf dem Deckglas führt allerdings dazu, dass auch ein Teil der für die Dreifachsolarzelle nutzbaren Photonen reflektiert wird.

Ausgehend hiervon war es Aufgabe der vorliegenden Erfindung, bestehende Solarzellen auf Germanium-Basis zu verbessern und die beschriebenen Nachteile der Systeme aus dem Stand der Technik zu beseitigen. Insbesondere sollen hierbei derartige Halbleiterbauelemente auf einfache Weise so weitergebildet werden, dass zum einen eine Reflexion von Photonen, als auch eine Rückseitenpassivierung der Zelle bzw. eine Diffusionsbarriere realisiert wird.

Diese Aufgabe wird durch das Halbleiterbauelement mit den Merkmalen des Anspruchs 1 und das Verfahren zu dessen Herstellung mit den Merkmalen des Anspruchs 25 gelöst. In den Ansprüchen 29 und 30 werden erfindungsgemäße Verwendungen angegeben. Die weiteren abhängigen Ansprüche zeigen vorteilhafte Weiterbildungen auf.

Erfindungsgemäß wird ein Halbleiterbauelement bereitgestellt, das mindestens eine Halbleiterschicht mit einer einfallenden lichtzugewandten Vorderseite und einer Rückseite aufweist. Die Halbleiterschicht enthält dabei mindestens 50 At-% Germanium. Die Halbleiterschicht weist dabei zumindest rückseitig und zumindest bereichsweise mindestens eine Siliciumcarbid enthaltende Schicht auf.

Siliciumcarbid bringt dabei eine Vielzahl von Vorteilen mit, die es für den Einsatz in den erfindungsgemäßen Halbleiterbauelementen prädestinieren.

So zeichnet sich Siliciumcarbid durch eine besonders hohe Temperaturstabilität aus. Ebenso besitzt SiC hervorragende Eigenschaften bezüglich der Oberflächenpassivierung für Ge und Si-Ge. Darüberhinaus zeichnet Siliciumcarbid aus, dass es eine gute Diffusionsbarriere für Verunreinigungen aus benachbarten Schichten darstellt.

Diese mindestens eine Siliciumcarbid enthaltende Schicht kann dabei eine atomare bzw. elektrische Funktion und/oder eine optische Funktion aufweisen.

Die atomare bzw. elektrische Funktion bezieht sich auf eine elektrische Rückseitenpassivierung oder eine Diffusionsbarriere bei den erfindungsgemäßen Halbleiterbauelementen. Die Siliciumcarbid enthaltende Schicht kann dabei als Diffusionsbarriere für Metalle und Verunreinigungen aus Schichten, die unterhalb der Solarzelle liegen, dienen. Eine weitere atomare bzw. elektrische Funktion betrifft die Möglichkeit, dass die Siliciumcarbid enthaltende Schicht als Quelle für Wasserstoff oder Dotierstoffe dient.

Die optische Funktion der Siliciumcarbid enthaltenden Schicht betrifft die Reflexion von Photonen mit einer Energie nahe oder kleiner der Bandlückenenergie des Solarzellenmaterials. Hierdurch kann der Weg für bandkantennahes Licht mit einer geringen Absorption durch das Solarzellenmaterial etwa verdoppelt werden. Dies ist insbesondere für dünne Solarzellen von Vorteil. Zudem kann langwellige Infrarotstrahlung mit einer Energie kleiner als die Bandlücke der Solarzelle aus der Zelle herausreflektiert werden. Hierdurch wird eine Erwärmung der Zelle durch die Absorption dieser Strahlung im Rückseitenkontakt vermieden. Dies ist insbesondere für Solarzellen im Weltraum, oder für die Thermophotovoltaik von Bedeutung.

Die mindestens eine Siliciumcarbid enthaltende Schicht stellt vorzugsweise einen Reflektor für Strahlung mit einer Wellenlänge > 1600 nm dar. Die Siliciumcarbid-Schicht(en) weisen dabei einen Brechungsindex im Bereich von 1,6 bis 3,6 auf. Eine bevorzugte Variante sieht vor, dass das Halbleiterbauelement mehrere Siliciumcarbid enthaltende Schichten mit unterschiedlichen Brechungsindizes aufweist. In diesem Falle kann dann das Schichtsystem aus Siliciumcarbid enthaltenden Schichten als Bragg-Reflektor fungieren.

Vorzugsweise weist die mindestens eine Siliciumcarbid enthaltende Schicht eine Dicke von 100 bis 500 nm auf. Sie besteht dabei vorzugsweise aus amorphem Siliciumcarbid oder enthält im Wesentlichen amorphes Siliciumcarbid.

Der Kohlenstoffgehalt der Siliciumcarbid-Schicht bzw. der im Wesentlichen aus Silicium und Kohlenstoff bestehenden Schicht liegt vorzugsweise im Bereich von 5 bis 95 At.-%. Bei einem Kohlenstoffgehalt der Siliciumcarbid-Schicht bzw. der im Wesentlichen aus Silicium und Kohlenstoff bestehenden Schicht von 5 At.-% beträgt der Brechungsindex dieser Schicht etwa 3,6, bei einem Kohlenstoffgehalt der Siliciumcarbid-Schicht von 95 At.-% bei etwa 1,6.

Weiterhin ist es bevorzugt, dass die mindestens eine Siliciumcarbid enthaltende Schicht elektrisch leitfähig ist.

In einer weiteren vorteilhaften Ausführungsform kann die mindestens eine Siliciumcarbid enthaltende Schicht dotiert sein. Als Dotierstoffe kommen hier beispielsweise Phosphor, Bor oder Stickstoff in Frage.

Die Halbleiterschicht weist vorzugsweise eine Dicke ≥ 100 µm und < 700 µm auf.

Die Halbleiterschicht besteht dabei vorzugsweise aus Germanium oder SiₓGe₁₋ₓ mit 0 < x < 0,5.

Eine weitere bevorzugte Ausführungsform sieht vor, dass auf der der Halbleiterschicht abgewandten Seite der mindestens einen Siliciumcarbid enthaltenden Schicht zumindest bereichsweise eine dielektrische Schicht aufgebracht ist. Als dielektrische Materialien kommen hier z.B. Siliciumoxid, Siliciumnitrid, Magnesiumfluorid, Tantaloxid oder Mischungen hiervon in Frage.

Weiterhin kann auf der der Halbleiterschicht abgewandten Seite von der mindestens einen Siliciumcarbid enthaltenden Schicht oder von der dielektrischen Schicht zumindest bereichsweise eine elektrisch kontaktierende Schicht aufgebracht sein, die den elektrischen Kontakt zur Halbleiterschicht herstellt. Als kontaktierende Materialien kommen hier insbesondere Aluminium, Gold, Silber, Palladium, Titan, Nickel oder Legierungen hiervon in Frage. Die elektrisch kontaktierende Schicht steht dabei bereichsweise im unmittelbaren elektrischen Kontakt zu der Halbleiterschicht. Dies kann beispielsweise durch Lasergefeuerte oder photolithographisch definierte Punktkontakte realisiert werden. Ebenso ist es aber auch möglich, eine elektrisch leitfähige Siliciumcarbid-Schicht zu verwenden, wodurch dann auf die beschriebenen Punktkontakte verzichtet werden kann.

Vorzugweise ist das Halbleiterbauelement eine Thermophotovoltaikzelle. In diesem Fall erfüllt die Siliciumcarbid enthaltende Schicht im wesentlichen drei Funktionen:
1. Reflexion von Wellenlängen zwischen 1600 bis 1850 nm, um die Absorption dieser Photonen in der Germanium Zelle zu erhöhen. Germanium hat eine Bandlückenenergie von 0,67 eV und absorbiert demnach Photonen mit einer Wellenlänge kleiner 1850 nm. Im Wellenlängenbereich zwischen 1600 bis 1850 nm ist Germanium ein indirekter Halbleiter mit einer geringen Absorption. Durch die Reflexion der Photonen in diesem Wellenlängenbereich zurück in die Germanium Zelle wird die Absorptionswahrscheinlichkeit erhöht.
2. Reflexion von Wellenlängen größer 1850 nm zurück zum Strahlungsemitter, um diese Photonen zu recyceln. Das langweilige Licht kann so dazu genutzt werden, den Emitter auf seiner hohen Temperatur zu halten. Anderenfalls würden diese Photonen im Rückseitenkontakt der Germanium-Zelle absorbiert werden und dort zu einer unerwünschten Erwärmung der Zelle beitragen.
3. Rückseitenpassivierung der Germanium-Zelle. Durch eine Siliciumcarbid-Schicht auf der Rückseite der Germanium Zellstruktur können Minoritätsladungsträger an dieser Grenzschicht reflektiert werden. Die Oberflächenrekombination kann deutlich verbessert werden. Hierdurch lassen sich höhere Effizienzen für die Umwandlung der Strahlung in elektrische Energie erzielen.

Eine weitere bevorzugte Variante sieht vor, dass das Halbleiterbauelement eine III-V-Mehrfachsolarzelle auf Germaniumbasis ist.

Durch die erfindungsgemäße Siliciumcarbid enthaltende Schicht, die auf der Rückseite dieser Mehrfachsolarzelle angeordnet ist, lässt sich das langwellige Sonnenlicht aus der Solarzelle herausreflektieren und es kann somit die Arbeitstemperatur der Solarzelle verringert werden. Weiter kann durch eine Reflexion von Wellenlängen zwischen 1600 bis 1850 nm zurück in die Germaniumzelle die Absorptionswahrscheinlichkeit dieser Photonen in der Germanium-Zelle erhöht werden.

Weiterhin wurde festgestellt, dass sich die Siliciumcarbid enthaltende Schicht hervorragend zur Rückseitenpassivierung dieser Mehrfachsolarzellen eignet. Dies bedeutet, dass eine Schicht aus Siliciumcarbid auf der Rückseite dieser Solarzellen die Rekombinationsgeschwindigkeit für Minoritätsladungsträger verringert. Bei einem Ge-Wafer mit 500 µm Dicke und p = 2*10¹⁵ cm⁻³ erhöht sich die effektive Lebensdauer von 15 bis 20 µs ohne Passivierung auf 130 bis 200 µs nach der Abscheidung einer Siliciumcarbid-Schicht mit einer Dicke von 100 nm auf beiden Seiten des Substrats.

Erfindungsgemäß wird ebenso ein Verfahren zur Herstellung eines Halbleiterbauelements, wie es zuvor beschrieben wurde, bereitgestellt, bei dem ein Germanium-haltiger Wafer in eine Reaktionskammer eingebracht wird und mittels plasmaunterstützter chemischer Gasphasenabscheidung (PECVD), thermischer CVD (RTCVD) oder Sputtern mindestens eine Siliciumcarbid enthaltende Schicht abgeschieden wird.

Vorzugsweise erfolgt vor der Abscheidung eine Plasmareinigung der Oberfläche des Substrats.

Als Prozessgase werden vorzugsweise Methan (CH₄) und Silan (SiH₄) verwendet. Über die Gasflüsse dieser beiden Prozessgase kann dabei die Stöchiometrie der Schichten und damit deren Funktion eingestellt werden.

Verwendung finden die beschriebenen Halbleiterbauelemente sowohl als Thermovoltaikzellen als auch als III-V-Mehrfachsolarzellen.

Anhand der nachfolgenden Figuren soll der erfindungsgemäße Gegenstand näher erläutert werden, ohne diesen auf die hier gezeigten speziellen Ausführungsformen einschränken zu wollen.
- Fig. 1: zeigt anhand einer schematischen Darstellung den Aufbau einer Germanium-Thermophotovoltaikzelle,
- Fig. 2: zeigt ein Reflexionsspektrum einer Germanium-Thermophotovoltaikzelle gemäß Fig. 1,
- Fig. 3: zeigt anhand einer schematischen Darstellung den Aufbau einer Dreifachsolarzelle gemäß dem Stand der Technik,
- Fig. 4: zeigt den Einsatz eines erfindungsgemäßen Halbleiterbauelementes in Form einer Germanium-Thermophotovoltaikzelle in einem Thermophotovoltaiksystem,
- Fig. 5: zeigt anhand einer schematischen Darstellung eine Variante eines erfindungsgemäßen Halbleiterbauelements in Form einer Germanium-Thermophotovoltaikzelle,
- Fig. 6: zeigt den schematischen Aufbau einer erfindungsgemäßen III-V-Mehrfachzellenstruktur.

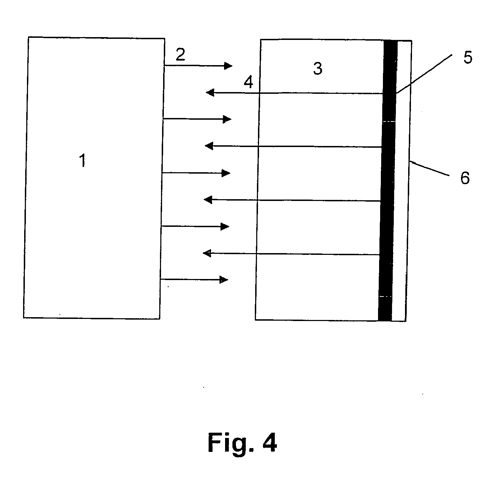

In Fig. 4 soll schematisch die optische Funktion des erfindungsgemäßen Halbleiterbauelements verdeutlicht werden. Der Emitter 1 strahlt eine Schwarzkörperstrahlung 2 mit einer Temperatur von 1000 bis 1500 °C ab. Die Germanium-Thermophotovoltaikzelle 3 wandelt den Teil des Spektrums mit Wellenlängen bis 1850 nm in elektrischen Strom um. Das langwelligere Licht wird meist im Rückseitenkontakt 6 absorbiert und führt zu einer unerwünschten Erwärmung der Zelle. Daher ist gemäß der vorliegenden Erfindung zwischen Photovoltaikzelle 3 und Rückseitenkontakt 6 eine Siliciumcarbid enthaltende Schicht 5 als Rückseitenreflektor enthalten. Dieser Rückseitenreflektor reflektiert Licht 4 mit einer Wellenlänge größer 1600 nm.

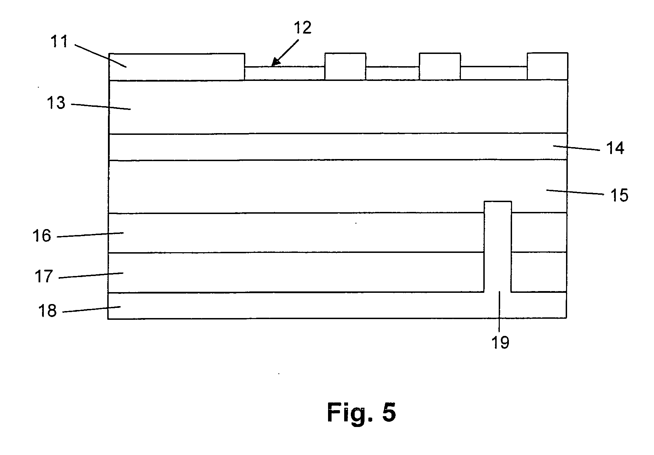

Fig. 5 zeigt im Detail den Aufbau einer erfindungsgemäßen Germanium-Thermophotovoltaikzelle. An der zum Licht gewandten Oberfläche ist ein Vorderseitenkontakt 11 angeordnet, der durch Bereiche mit einer Antireflexschicht 12 unterbrochen sein kann. Unterhalb dieser Schichten ist eine Fensterschicht bzw. Vorderseitenpassivierung 13 angeordnet. Unter dieser wiederum ist das Substrat bestehend aus einem Germanium-Emitter 14 und einer Germanium-Basis 15 angeordnet. Erfindungswesentlich ist die nun folgende Siliciumcarbid enthaltende Schicht 16, die im vorliegenden Fall als Rückseitenpassivierung dient. Auf deren Rückseite ist ein Reflektor aus mehreren Schichten mit unterschiedlichem Brechungsindex, der z.B. aus Siliciumcarbid-, Siliciumoxid- oder Siliciumnitrid-Schichten bestehen kann, angeordnet. An der Rückseite befindet sich schließlich eine Kontaktierung 18, die z.B. lasergefeuerte oder photolithographisch definierte Punktkontakte 19 aufweist. Im Falle einer leitfähigen Siliciumcarbid-Schicht kann auf diese Punktkontakte auch verzichtet werden.

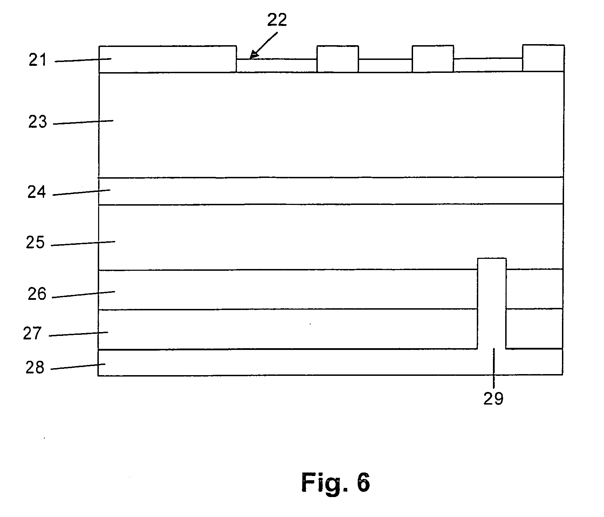

Fig. 6 zeigt den Aufbau einer erfindungsgemäßen III-V-Mehrfachsolarzellenstruktur. Diese weist einen Vorderseitenkontakt 21 auf, der bereichsweise durch eine Antireflexschicht 22 unterbrochen ist. Auf der dem Licht abgewandten Seite schließt sich daran eine III-V-Mehrfachsolarzellenstruktur 23 an. Unter dieser ist eine Germanium-Teilzelle mit Germanium-Emitter 24 und Germanium-Basis 25 angeordnet. Auf deren Rückseite wiederum ist eine Siliciumcarbid enthaltende Schicht 26 zur Rückseitenpassivierung angeordnet. Der aus mehreren Schichten mit unterschiedlichem Brechungsindex bestehende Reflektor 27 kann aus Siliciumcarbid, Siliciumoxid oder Siliciumnitrid bestehen. Auf der Rückseite ist schließlich noch eine Rückseitenkontaktierung 28 aus Aluminium angeordnet, die einen lasergefeuerten oder photolithographisch definierten Punktkontakt 29 aufweist.

## Patentansprüche

1. Halbleiterbauelement enthaltend mindestens eine mindestens 50 At-% Germanium enthaltende Halbleiterschicht mit einer dem einfallendem Licht zugewandten Vorderseite und einer Rückseite, wobei die Halbleiterschicht zumindest rückseitig und zumindest bereichsweise mindestens eine Siliciumcarbid enthaltende Schicht aufweist.

2. Halbleiterbauelement nach Anspruch 1,
**dadurch gekennzeichnet, dass** die mindestens eine Siliciumcarbid enthaltende Schicht eine Oberflächenpassivierungsschicht für die Halbleiterschicht ist.

3. Halbleiterbauelement nach einem der vorhergehenden Ansprüche,
**dadurch gekennzeichnet, dass** die mindestens eine Siliciumcarbid enthaltende Schicht ein Reflektor für Strahlung mit einer Wellenlänge größer 1600 nm ist.

4. Halbleiterbauelement nach einem der vorhergehenden Ansprüche,
**dadurch gekennzeichnet, dass** die mindestens eine Siliciumcarbid enthaltende Schicht einen Brechungsindex im Bereich von 1,6 bis 3,6 aufweist.

5. Halbleiterbauelement nach einem der vorhergehenden Ansprüche,
**dadurch gekennzeichnet, dass** das Halbleiterbauelement mehrere Siliciumcarbid enthaltende Schichten mit unterschiedlichen Brechungsindizes aufweist.

6. Halbleiterbauelement nach dem vorhergehenden Anspruch,
**dadurch gekennzeichnet, dass** die Siliciumcarbid enthaltenden Schichten als Bragg-Reflektor fungieren.

7. Halbleiterbauelement nach einem der vorhergehenden Ansprüche,
**dadurch gekennzeichnet, dass** die mindestens eine Siliciumcarbid enthaltende Schicht eine Dicke von 100 bis 500 nm aufweist.

8. Halbleiterbauelement nach einem der vorhergehenden Ansprüche,
**dadurch gekennzeichnet, dass** die mindestens eine Siliciumcarbid enthaltende Schicht aus amorphem Siliciumcarbid besteht oder dieses im wesentlichen enthält.

9. Halbleiterbauelement nach einem der vorhergehenden Ansprüche,
**dadurch gekennzeichnet, dass** die mindestens eine Siliciumcarbid enthaltende Schicht elektrisch leitfähig ist.

10. Halbleiterbauelement nach einem der vorhergehenden Ansprüche,
**dadurch gekennzeichnet, dass** die mindestens eine Siliciumcarbid enthaltende Schicht mit Phosphor, Bor und/oder Stickstoff dotiert ist.

11. Halbleiterbauelement nach einem der vorhergehenden Ansprüche,
**dadurch gekennzeichnet, dass** das Halbleiterbauelement eine Reflektivität für Strahlung im Wellenlängenbereich von 1800 bis 4000 nm von mehr als 60 %, insbesondere von mehr als 80 % aufweist.

12. Halbleiterbauelement nach einem der vorhergehenden Ansprüche,
**dadurch gekennzeichnet, dass** die Halbleiterschicht eine Dicke größer oder gleich 100 µm und kleiner 700 µm aufweist.

13. Halbleiterbauelement nach einem der vorhergehenden Ansprüche,
**dadurch gekennzeichnet, dass** die Halbleiterschicht mindestens 90 At-% Germanium enthält.

14. Halbleiterbauelement nach einem der vorhergehenden Ansprüche,
**dadurch gekennzeichnet, dass** die Halbleiterschicht aus SiₓGe₁₋ₓ mit 0 < x < 0,5 besteht.

15. Halbleiterbauelement nach einem der vorhergehenden Ansprüche,
**dadurch gekennzeichnet, dass** die mindestens eine Siliciumcarbid enthaltende Schicht flächig auf der Halbleiterschicht angeordnet ist.

16. Halbleiterbauelement nach einem der vorhergehenden Ansprüche,
**dadurch gekennzeichnet, dass** auf der der Halbleiterschicht abgewandten Seite der mindestens einen Siliciumcarbid enthaltenden Schicht zumindest bereichsweise eine dielektrische Schicht aufgebracht ist.

17. Halbleiterbauelement nach dem vorhergehenden Anspruch,
**dadurch gekennzeichnet, dass** die dielektrische Schicht aus Siliciumoxid, Siliciumnitrid, Magnesiumfluorid, Tantaloxid oder Mischungen hiervon besteht oder diese im wesentlichen enthält.

18. Halbleiterbauelement nach einem der vorhergehenden Ansprüche,
**dadurch gekennzeichnet, dass** auf der der Halbleiterschicht abgewandten Seite der mindestens einen Siliciumcarbid enthaltenden Schicht oder der dielektrischen Schicht zumindest bereichsweise eine elektrisch kontaktierende Schicht aufgebracht ist, die den elektrischen Kontakt zur Halbleiterschicht herstellt.

19. Halbleiterbauelement nach dem vorhergehenden Anspruch,
**dadurch gekennzeichnet, dass** die elektrisch kontaktierende Schicht aus Aluminium, Gold, Silber, Palladium, Titan, Nickel oder Legierungen hiervon besteht oder im wesentlichen enthält.

20. Halbleiterbauelement nach einem der beiden vorhergehenden Ansprüche,
**dadurch gekennzeichnet, dass** die elektrisch kontaktierende Schicht bereichsweise in unmittelbarem elektrischen Kontakt mit der Halbleiterschicht steht.

21. Halbleiterbauelement nach einem der vorhergehenden Ansprüche,
**dadurch gekennzeichnet, dass** das Halbleiterbauelement eine Thermophotovoltaikzelle ist.

22. Halbleiterbauelement nach dem vorhergehenden Anspruch,
**dadurch gekennzeichnet, dass** die Siliciumcarbid enthaltende Schicht auf der Licht abgewandten Seite der Photovoltaikzelle angeordnet ist.

23. Halbleiterbauelement nach dem vorhergehenden Anspruch,
**dadurch gekennzeichnet, dass** das Halbleiterbauelement eine Thermophotovoltaikzelle zur Umwandlung der Strahlung eines thermischen Emitters mit einer Temperatur von 800 bis 2000 °C in elektrischen Strom ist.

24. Halbleiterbauelement nach einem der vorhergehenden Ansprüche,
**dadurch gekennzeichnet, dass** das Halbleiterbauelement eine III-V-Mehrfachsolarzelle ist.

25. Verfahren zur Herstellung eines Halbleiterbauelementes nach einem der vorhergehenden Ansprüche, bei dem ein Germanium enthaltendes Substrat in eine Reaktionskammer eingebracht wird und mittels plasmaunterstützter chemischer Gasphasenabscheidung (PECVD), thermischer CVD (RTCVD) oder Sputtern mindestens eine Siliciumcarbid enthaltende Schicht abgeschieden wird.

26. Verfahren nach Anspruch 25,
**dadurch gekennzeichnet, dass** vor der Abscheidung eine Plasmareinigung der Oberfläche des Substrats erfolgt.

27. Verfahren nach einem der Ansprüche 25 oder 26,
**dadurch gekennzeichnet, dass** als Prozessgase Methan (CH₄) und Silan (SiH₄) verwendet werden.

28. Verfahren nach einem der Ansprüche 25 bis 27,
**dadurch gekennzeichnet, dass** über die Gasflüsse der Prozessgase CH₄ und SiH₄ die Stöchiometrie der Schichten und damit deren Funktion eingestellt wird.

29. Verwendung des Halbleiterbauelementes nach einem der Ansprüche 1 bis 24 als Thermophotovoltaikzelle.

30. Verwendung des Halbleiterbauelementes nach einem der Ansprüche 1 bis 24 als III-V-Mehrfachsolarzelle.
